# DEMANDE DE BREVET EUROPEEN

(11) **EP 1 132 972 A1**
(43) Date de publication de la demande: **12.09.2001**
(21) Numéro de dépôt: 00410165.5
(22) Date de dépôt: 27.12.2000
(51) Int. Cl.: H01L 29/861

(54) **Dispositif écrêteur à résistance négative**

(30) Priorité: 28.12.1999 FR 9916602
(71) Demandeur: STMicroelectronics S.A., 94250 Gentilly (FR)
(72) Inventeur: Bernier, Eric, 37390 Mettray (FR); Pezzani, Robert, 37210 Vouvray (FR)
(74) Mandataire: de Beaumont, Michel

(57) **Abrégé**

L'invention concerne un dispositif écrêteur destiné à absorber des pics de courant de 1 à 10 ampères, constitué d'un transistor bipolaire NPN vertical dont la base n'est pas connectée, dont l'émetteur est connecté à une borne sur laquelle sont susceptibles d'apparaître des pics de tension positifs et dont le collecteur est relié à la masse, les paramètres du transistor étant réglés pour qu'il présente une résistance dynamique négative.

## Description

La présente invention concerne un dispositif de protection contre les surtensions.

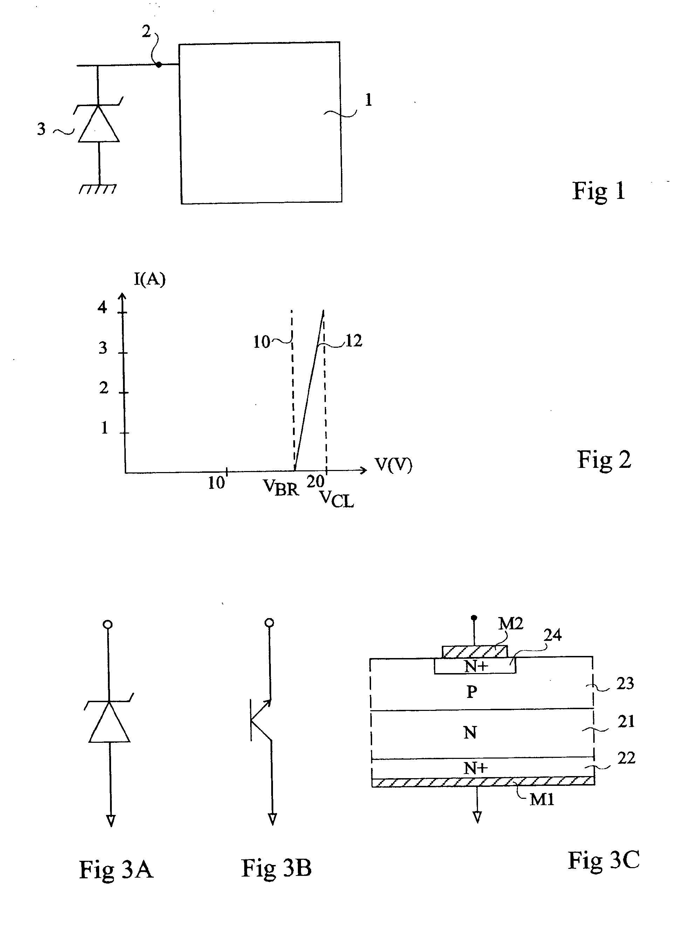

De façon classique, des circuits électroniques, par exemple des circuits intégrés comprennent un grand nombre d'entrées, et il est susceptible de se produire sur chacune de ces entrées des pics de tension liés à des surtensions sur les lignes de connexion ou à des décharges électrostatiques. Ainsi, de façon classique, comme l'illustre la figure 1, chacune des entrées sensibles 2 d'un circuit intégré 1 est associée à un dispositif de protection 3, qui est représenté en figure 1 sous forme d'une diode à avalanche.

On a considéré en figure 1 le seul cas où il est susceptible de se produire une surtension positive sur l'entrée 2. De façon classique, l'homme de l'art saura prévoir des systèmes permettant d'éliminer des surtensions négatives.

Par ailleurs, en dehors des dispositifs de protection de type écrêteur tels que la diode à avalanche 3 illustrée en figure 1, il existe également des dispositifs de type à retournement, dans lesquels, après une surtension, la tension aux bornes du dispositif chute à une valeur pratiquement nulle. Un exemple de dispositif à retournement est une diode de Shockley. En pratique, l'utilisateur choisira d'adopter un dispositif écrêteur (diode à avalanche) ou un dispositif à retournement (diode de Shockley) selon ses besoins et selon la configuration d'ensemble du circuit. On s'intéressa ici uniquement aux dispositifs de protection de type écrêteur.

La figure 2 représente la caractéristique courant-tension d'un dispositif écrêteur, pour lequel la tension de claquage V_{BR} est de l'ordre de 17 volts. On s'intéresse à des composants susceptibles de laisser passer des courants relativement importants. On a représenté à titre d'exemple des courbes entre 1 et 4 ampères. La courbe idéale d'un composant écrêteur serait la courbe représentée en pointillés sous la référence 10. En pratique, un composant écrêteur présente toujours une certaine résistance dynamique positive, et le phénomène va en s'accentuant pour un composant donné quand celui-ci s'échauffe. Ainsi, par exemple, un composant ayant une tension de claquage de 17 volts, verra la tension de verrouillage à ses bornes, V_{CL}, augmenter jusqu'à par exemple 20 volts quand le courant qui le traverse atteint quatre ampères. Cette augmentation de la tension réelle aux bornes des composants écrêteurs constitue un inconvénient important. En effet, la tension de claquage du composant est choisie en tenant compte de deux limites. La tension V_{BR} doit être supérieure à la tension normale maximale susceptible d'arriver sur la borne d'entrée 2. D'autre part, elle doit être inférieure aux tensions susceptibles de dégrader les composants disposés derrière l'entrée 2. En fait, dans de nombreux cas, cette marge est très réduite. De plus, les normes actuelles imposent de protéger certains circuits contre des surtensions particulièrement importantes susceptibles de laisser passer des courants relativement intenses dans le composant de protection. Il importe donc d'éviter autant que possible que la tension aux bornes du composant écrêteur après sa mise en avalanche devienne supérieure à la tension de claquage choisie V_{BR}.

Une solution pour réduire la différence entre les tensions V_{CL} et V_{BR} consiste à augmenter la surface de la diode. En effet, une diode de surface cinq fois plus grande qu'une autre présentera, pour un courant donné, une différence V_{CL} - V_{BR} cinq fois plus faible, mais elle coûtera sensiblement cinq fois plus cher...

C'est un objet de la présente invention que de résoudre ce problème.

Pour atteindre cet objet, la présente invention prévoit un dispositif écrêteur destiné à absorber des pics de courant de 1 à 10 ampères, constitué d'un transistor bipolaire NPN vertical dont la base n'est pas connectée, dont l'émetteur est connecté à une borne sur laquelle sont susceptibles d'apparaître des pics de tension positifs et dont le collecteur est relié à la masse, les paramètres du transistor étant réglés pour qu'il présente une résistance dynamique négative.

Selon un mode de réalisation de la présente invention, la résistance de base est inférieure à 1500 ohms/□.

Selon un mode de réalisation de la présente invention, la disposition relative de l'émetteur et de la base est telle que le claquage se produise en volume.

Selon un mode de réalisation de la présente invention, l'émetteur déborde par rapport à la base et la périphérie de l'émetteur est entourée d'une région de type P plus faiblement dopée que la base.

Selon un mode de réalisation de la présente invention, la base déborde par rapport à l'émetteur, la périphérie de l'émetteur étant constituée d'une région de type N faiblement dopée.

On notera que l'on a déjà proposé d'utiliser un transistor NPN fonctionnant en dipôle, sa base n'étant pas connectée, et une tension positive par rapport au collecteur étant appliquée à l'émetteur, par exemple dans la demande de brevet européen EP-A-0881693 (B3564) ou dans la demande de brevet japonais 5561828 déposée le ler novembre 1978. Toutefois, ces documents proposent d'utiliser de tels composants comme références de tension. Il n'y a donc en fait pas de relation avec les applications envisagées. En effet, une référence de tension est destinée à présenter une caractéristique très verticale, similaire à la caractéristique 10 représentée en figure 2, mais seulement sur une plage de courant pouvant aller de quelques microampères à quelques milliampères alors que la présente invention concerne des composants de protection pouvant laisser circuler des courants de plusieurs ampères. Les transistors proposés dans les deux documents cités auraient en fait, pour des courants de l'ordre de l'ampère, une caractéristique d'écrêtage à résistance dynamique positive.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente l'utilisation classique d'un composant de protection ;
la figure 2 représente la caractéristique classique d'un composant écrêteur ;
la figure 3A représente une vue schématique d'un composant écrêteur ;
la figure 3B représente symboliquement un composant écrêteur selon la présente invention ;
la figure 3C représente une vue en coupe schématique d'un composant écrêteur selon la présente invention ;
les figures 4A et 4B représente des variantes de réalisation d'un composant écrêteur selon la présente invention ;
la figure 5 représente des caractéristiques courant-tension de composants écrêteurs selon la présente invention ;
la figure 6 représente des caractéristiques courant-tension de composants écrêteurs selon la présente invention.

Ainsi, la présente invention vise à réaliser un composant écrêteur, dont le symbole correspond à ce qui est représenté en figure 3A, pour lequel la chute de tension aux bornes après claquage V_{CL} est très peu supérieure à la tension de claquage V_{BR}, ou même, et de préférence, est inférieure à la tension V_{BR}, sans toutefois revenir vers zéro comme dans le cas d'un composant à retournement.

Pour cela, la présente invention propose d'utiliser un transistor sans connexion de base tel qu'illustré en figure 3B dans des conditions particulières. Ce transistor est utilisé dans le sens inverse du sens usuel. La borne de collecteur du transistor est reliée à la masse et correspond à l'anode de la diode à avalanche et la borne d'émetteur du transistor est reliée à un point susceptible de recevoir une impulsion de haute tension positive et correspond à la cathode de la diode à avalanche. Ainsi, on adoptera une structure de transistor NPN telle que représentée très schématiquement en figure 3C comprenant un substrat 21 de type N correspondant au collecteur du transistor et comprenant du côté de sa face arrière une région surdopée 21 dont est solidaire une métallisation Ml. Du côté de la face supérieure sont formées une couche de base 23 de type P et une couche d'émetteur 24 de type N dont est solidaire une métallisation M2. La métallisation M1 est normalement reliée à la masse et la métallisation M2 est reliée à une borne à protéger susceptible de recevoir une surtension positive.

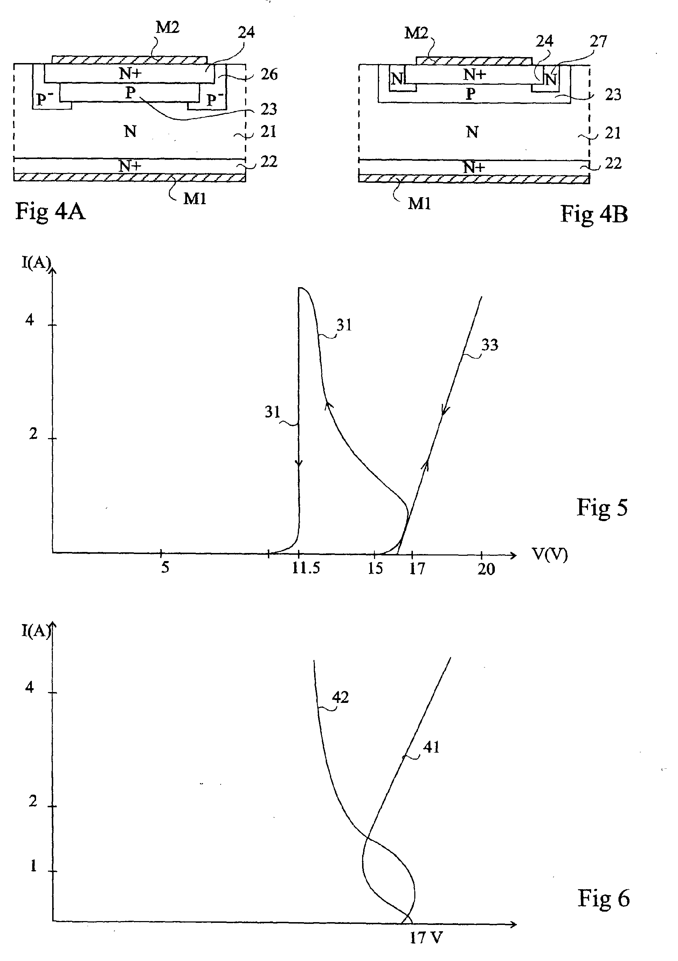

De préférence, pour favoriser un claquage en volume de la jonction émetteur-base, on choisira une structure telle que représentée en figure 4A ou 4B. En effet, les expériences ont montré que le composant selon la présente invention présentait des effets satisfaisants seulement si l'on pouvait garantir un claquage en volume de la jonction émetteur-base.

Dans le mode de réalisation de la figure 4A, la couche 24 d'émetteur recouvre complètement la couche de base 23 et les périphéries des régions de base et d'émetteur sont entourées d'une région de type P faiblement dopée 26.

Dans le cas de la figure 4B, la région de base 23 déborde largement par rapport à la région d'émetteur 24 et la périphérie de cette région d'émetteur est entourée d'un anneau de type N faiblement dopé 27.

Les dispositions des figures 4A et 4B sont connues pour favoriser un claquage en volume de la jonction émetteur-base et sont susceptibles de diverses variantes. Par exemple, la région P 26 en figure 4A ou la région de base 23 en figure 4B peut s'étendre jusqu'à la périphérie du composant si le composant représenté est un composant unitaire et non pas une portion d'un composant monolithique comprenant plusieurs composants élémentaires dont celui représenté en figures 4A ou 4B.

Selon un autre aspect de la présente invention, il importe que le dopage de la région de base intrinsèque, c'est-à-dire la portion de la région de type P 23 se trouvant sous la région d'émetteur 24, soit choisi dans une fourchette déterminée. En particulier, il est préconisé de choisir une région de base intrinsèque ayant un niveau de dopage inférieur à 1500 ohms/□.

La figure 5 illustre le résultat de simulations réalisées par la demanderesse sur des structures du type de celle de la figure 3C :
- pour une résistance de base intrinsèque, ou plus exactement de base pincée sous l'émetteur, de l'ordre de 1500 ohms/□, on a obtenu la courbe désignée par la référence 31 ; c'est-à-dire que, pendant la présence de l'impulsion, le courant dans le transistor montait jusqu'à une valeur légèrement supérieure à quatre ampères pour rechuter verticalement ; pendant la phase de croissance du courant, la tension aux bornes du transistor, au lieu de croître comme dans le cas d'un écrêteur classique dont la caractéristique est représentée en figure 2, décroissait jusqu'à atteindre une valeur de l'ordre de 11,5 V ; à la fin de l'impulsion, la décroissance de tension est sensiblement verticale ; en d'autres termes, la caractéristique courant-tension présente une résistance dynamique négative ;
- avec la même configuration, pour une résistance par carré de la région de base intrinsèque de l'ordre de 2200 ohms/□, on a obtenu une résistance dynamique positive illustrée par la courbe 33 qui est très similaire à la courbe 12 de la figure 2.

On notera que dans toutes ces courbes, la partie initiale, pour des valeurs très faibles du courant, inférieures à 100 milliampères, n'est pas représentée et donc les caractéristiques de diodes de référence présentées dans les demandes de brevet susmentionnées ne transparaissent pas dans ces courbes. Il semble d'ailleurs que ces caractéristiques ne soient pas obtenues ici, car, dans les demandes de brevet susmentionnées, la résistance de base est beaucoup plus élevée.

D'autre part, il sera clair que si l'on augmente le nombre de carrés occupés par le composant, la résistance de celui-ci diminuera et que l'on favorise la réduction de consommation du composant. Par exemple, en figure 6, la courbe 41 correspond à un transistor selon la présente invention ayant une résistance de base pincée de l'ordre de 600 ohms/□,. On notera que l'on quitte la zone à résistance négative dès que le courant traversant le transistor atteint une valeur de l'ordre de 1 ampère. Par contre, pour un transistor de 140 carrés de long, la courbe correspondante sera la courbe 42 dans laquelle on reste en résistance négative jusqu'à une valeur du courant supérieure à 4 ampères. La plage de courant dans laquelle on maintient l'effet de résistance dynamique négative pourra donc être réglée par un dimensionnement adéquat : plus on augmente le nombre de carrés, plus on augmente la plage de courant dans laquelle on maintient l'effet de résistance dynamique négative.

## Revendications

1. Dispositif écrêteur destiné à absorber des pics de courant de 1 à 10 ampères, caractérisé en ce qu'il est constitué d'un transistor bipolaire NPN vertical dont la base n'est pas connectée, dont l'émetteur est connecté à une borne sur laquelle sont susceptibles d'apparaître des pics de tension positifs et dont le collecteur est relié à la masse, les paramètres du transistor étant réglés pour qu'il présente une résistance dynamique négative.

2. Dispositif selon la revendication 1, caractérisé en ce que la résistance de base est inférieure à 1500 ohms/□.

3. Dispositif selon la revendication 1, caractérisé en ce que la disposition relative de l'émetteur et de la base est telle que le claquage se produise en volume.

4. Dispositif selon la revendication 3, caractérisé en ce que l'émetteur déborde par rapport à la base et en ce que la périphérie de l'émetteur est entourée d'une région de type P plus faiblement dopée que la base.

5. Dispositif écrêteur selon la revendication 3, caractérisé en ce que la base déborde par rapport à l'émetteur, la périphérie de l'émetteur étant constituée d'une région de type N faiblement dopée.
